# EUROPEAN PATENT APPLICATION

(11) **EP 1 122 799 A1**
(43) Date of publication of application: **08.08.2001**
(21) Application number: 00101932.2
(22) Date of filing: 01.02.2000
(51) Int. Cl.: H01L 39/24

(54) **Stainless steel substrate for superconducting films**

(71) Applicant: Zentrum für Funktionswerkstoffe, Gemeinnützige Gesellschaft mbH, 37073 Göttingen (DE); Alcatel Kabel AG & Co., 30179 Hannover (DE)
(72) Inventor: Usoskin, Dr. Alexander, 37075 Göttingen (DE); Freyhardt, Prof. Dr. Herbert, 37085 Göttingen (DE); Harten, Friedrich, 315266 Stadthagen (DE)
(74) Representative: Lins, Edgar, Dipl.-Phys. Dr.jur.

(57) **Abstract**

A superconducting element comprising a high temperature superconducting film deposited on a technical substrate (1) consisting of a stainless steel containing Ni, Cr, and Fe and possible further alloying elements, preferably Mn and Si, can be produced with great lengths and high critical current densities of the superconducting layer if the stainless steel is a heat resistant steel containing 16 to 25 % Ni and 18 to 28 % Cr, rest iron and said possible alloying elements.

## Description

The present invention relates to a superconducting element comprising a high temperature superconducting film deposited on a technical substrate consisting of a stainless steel containing Ni, Cr, and Fe and possible further alloying elements, preferably Mn and Si.

The recent progress in the technology of high temperature superconducting (HTSC) films demonstrates the first real possibility of obtaining high T_{c} superconducting layers with high critical durrent densities (j_{c}) of > 4 MA/cm² on various single crystalline substrates. A lot of methods based on pulsed laser deposition, molecular beam deposition, sputtering, etc. were developed and successfully applied for this purpose.

A crucial point in these developments is an adaquate choice of the substrate material which can be manufactured in larger pieces (from 1 to 100 m) and which is not as expensive as single crystalls. Because of this reason, a lot of attemps have been made to employ for this aim a number of different "technical" materials as Ni (Garcia-Moreno Usoskin, Freyhardt et al., IOP Conf. Ser. 158 (1997) 909 - 912), Ittrium Stabilized Zirconia (YSZ) ceramics (Kinder et al. IEEE Trans. on Appl. Superconductivity, Vol. 5 No. 2 (1995) 1575 - 1580), Hastelloy (Quiton et al. in High Temperature Superconductivity, Research review 1998, ed. W.Y. Liang, 135 - 141), Inconel, etc. Between the HTSC films and the substrate a buffer layer is deposited which serves for influencing the texture of the deposited HTSC film and for acting as a diffusion barrier inhibiting an ion diffusion between substrate and HTSC film. The most usual HTSC film which is preferably used for the present invention is YBa₂Cu₃O_{7-δ}. In the case of polycrystalline substrates of the above-mentioned kind an artificially induced alignment by ion-beam assisted deposition (IBAD) Iijima et al., J. Appl. Phys. 74 (1993), 1905), inclined substrate deposition (ISD) (Hasegawa et al. The 1998 Internationale Workshop on Superconductivity, 73 - 76) of the buffer layers or rolling assisted biaxially texturing of metallic substrate (RABiTs) (Goyal et al., Appl. Phys., Lett. 69, 1795) is required to provide a well textured growth of high-T_{c} films.

Nevertheless, no substrate material with sufficient properties has been found for long HTSC coated tapes. E.g. Ni sheets exhibit a high performance when used for smaller (1x1 cm²) substrates. For longer (> 10 cm) substrates a destroyment of high-T_{c} film occurs which is caused by local oxidation of the substrate because of oxygen diffusion through weak parts in the buffer layer. This is also valid for Inconel and, partly, for Hastelloy substrates. Ceramic substrates are shown to be sufficient to provide high critical currents in superconducting films, but they are not flexible enough to perform a winding in coils. All of substrates mentioned above are expensive. One square meter of each of them costs at present more than 1.000 DM.

The above-mentioned draw backs inhibit the use of HTSC films for new numerous fields of their industrial applications in electronics, HF-technique and power engineering where HTSC films on a single crystalline substrate are useless because of their strictly limited dimensions and lacking mechanical flexiblity.

Accordingly, it is an object of the present invention to provide a superconducting element of the above-mentioned kind which provide a high critical current density and a high transition temperature and allows a reduction of production costs.

According to the present invention this problem is solved by a superconducting element of the above-mentioned kind wherein the stainless steel is a heat resistant steel containing 16 to 25 % Ni and 18 to 28 % Cr, rest iron and said possible alloying elements. The superconducting element according to the present invention allows both an unexpected increase of the critical current densities and transition temperatures of high temperature superconducting films and to reduce drastically substrate price, at least, by a factor of 100. A reason of the improved film performance may be the optimal combination of the properties of the chosen substrate material, namely austenitic microstructure, high thermal expansion, peculiarities of surface structure, temperature resistance against oxidation, etc..

In a preferred embodiment of the present invention the steel shows an heat elongation of 15 to 18, preferably 17 x 10⁻⁶/K between 20° und 400 °C, of 16 to 19, preferably 18 x 10⁻⁶/K between 20° and 800 °C, of 17 to 20, preferably 19 x 10⁻⁶/K between 20° and 1000 °C and of 18 to 20.5, preferably 19.5 x 10⁻⁶/K between 20° and 1200 °C.

The properties of the stainless steel according to the present invention depend on the percentage range of Ni and Cr within said steel. Preferred amounts are 19 to 22 % Ni and 24 to 26 % Cr.

The steel may contain in addition 1 to 3 %, preferably 1.5 to 2.5 % Si and a usual Mn component of up to 2 %.

A special steel most preferred for the present invention is composed of

| | |
|---|---|
| C | 0 to 0.20 % |
| Si | 1.5 to 2.5 % |
| Mn | 0 to 2.00 % |
| P | 0 to 0.045 % |
| S | 0 to 0.030 % |
| Cr | 24.0 to 26.0 % |
| Ni | 19.0 to 22.0 % |
| N | 0 to 0.11 % |

rest iron and unavoidable impurities.

A steel of this kind is known under the EURO norm designation X15CrNiSi25-21 or as X15CrNiSi25-20 according to DIN E EN 10095 (12/95). Said steels are normally used as parts of furnaces which are heat resistant and have a high mechanical strength. The most preferred embodiment of the invention is a superconductor coated tape of the stainless steel as described.

### Brief description of the drawings

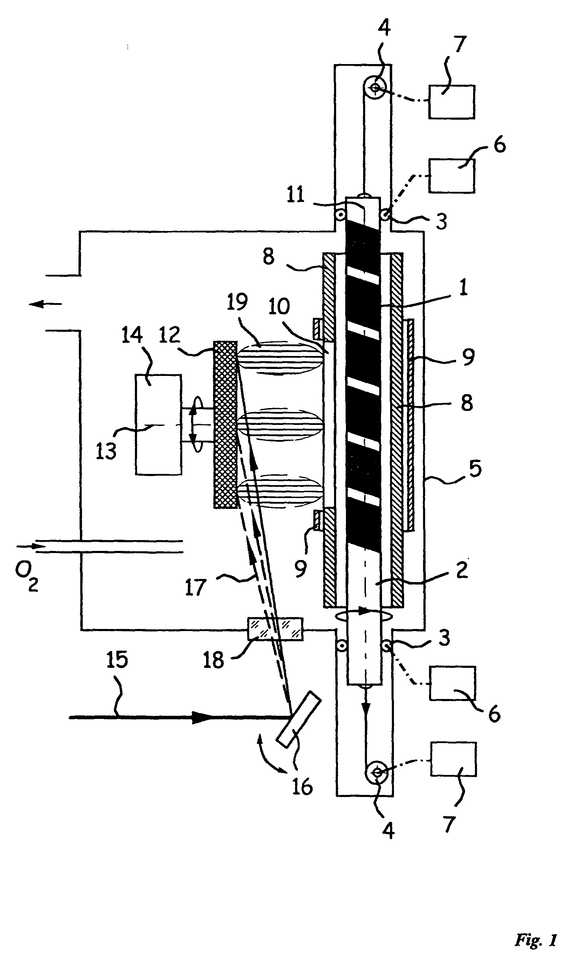

Figure 1 is a view schematically illustrating an apparatus for preparation of HTSC films on ribbon-type substrates in accordance with an embodiment of the present invention.

### Description of the preferred embodiment

In the apparatus illustrated in figure 1 a foil substrate 1 consisting of stainless steel is fixed in a helix form on a cylindrical tubular holder 2 with an outer diameter of 68 mm and mounted together with the holder in a motion guide based on rotating supports 3 and linear pulling devices 4 built in a vacuum chamber 5. The rotating supports as well as the pulling devices 4 are connected to motor drives 6, 7, respectively. In a film desposition area the substrate 1 with the holder 2 can be heated by a tubular quasi-equilibrium heater which consists of a heating element 8 and a rotating chopper 9. Heating element 8 is provided with one deposition window 10 and the chopper 9 is equipped with three of similar windows. All of the parts mentioned above are installed co-axially relatively to the rotation axis 11 of the tubular holder 2. Opposite to the deposition window 10 a ceramic target 12 is placed in the vacuum chamber 5. The target is based on YBa₂Cu₃O_{7-δ} composition. The target 12 is capable of linear oscillation direction perpendicular to the plane of the drawing of figure 1 and is capable also of periodic turns around axis 13 to provide variations of the azimuth of incoming layer beam relatively to the target. This allows to stabilize the laser plume during a long-term deposition process. The motions of the target 12 are provided by a 2-dimensional drive 14. To provide a large area pulsed laser deposition, the target 12 can be ablated by a pulsed laser beam 15 which after a reflection at an oscillating mirror 16 is capable of scanning the target surface by a deflected beam 17 entering the vacuum chamber 5 through a window 18. An excimer laser with a wavelength of 308 nm, an energy of pulses of 0,5 J, and a pulse repetition rate of 300 Hz was employed as a source of the laser beam.

In operation, the chamber is pumped down to a pressure of < 10⁻³ mbar and the substrate 1 with the holder 2 are heated up to the temperature of 760 °C. During the heating step and subsequent film deposition the chopper 9 rotates with the frequency of 23 Hz, and holder 2 rotates with the frequency of 4 Hz. Then the oxygen pressure of 0,4 mbar is introduced to the chamber. The oscillating motions of target 12 and of mirror 16 and the axial pulling of the holder 2 are started. The laser is turned on and the laser pulses are synchronized with phases of motions of chopper 9 and of mirror 16 so that each ablation pulse appears only at the moment when one of the deposition windows in the rotating chopper 9 coincides with the deposition window 10 in the heating element 8, i.e. the substrate 1 is exposed to a plasma plume 19. Due to the rotation of the holder 2 and scanning of the target surface with the laser beam, a homogeneous film deposition over the substrate surface is provided. After the film deposition the oxygen pressure in the chamber is increased up to 300 mbar within 10 min. Simultaneously, the substrate temperature is reduced down to 500 °C during said 10 min. and afterwards down to 150 °C during next 60 min.

### Example 1

0.1 mm-thick stainless steel with a composition of Ni 19 %, Cr 24 %, Si 2 %, Mn 1 %, and with the rest of iron was used as the substrate 1. Substrate surface was galvanically polished in water solution of H₃PO₄ (30 %), CrO₃ (15 %) and H₂SO₄ (7 %) using a current density of 0.5 A/cm². Polishing time was of 10 s. After the polishing the substrate 1 was thoroughly washed in de-ionized water in supersonic bath. Then the substrate was covered with an Ittrium Stabilized Zirconia 1 µm-thick buffer layer by IBAD.

By using the apparatus illustrated in figure 1 and described above the YBa₂Cu₃O_{7-α} film was deposited which showed a density of the critical current in said superconducting film measured at the temperature of 77 K of 2 MA/cm². Transition temperature was 90 K. No substrate oxidation was observed after 120 min. lasting film deposition process.

The price of the substrate is of 20 DM/m².

### Example 2

A 0.1 mm-thick stainless steel with the composition of Ni 25 %, Cr 24 %, Si 1,5 %, Mn 2 %, and with the rest of iron was used as the substrate 1. Buffer layer and superconducting film was applied as described in example 1.

The density of the critical current in the superconducting film was of 1.8 MA/cm². Transition temperature was 90 K. No substrate oxidation was observed after 120 min. lasting film deposition process.

The price of the substrate is of 25 DM/m².

### Example 3

A 0.1 mm-thick stainless steel with the composition of Ni 16 %, Cr 24 %, Si 2 %, Mn 1 %, and with the rest of iron was used as the substrate 1. Buffer layer and superconducting film was applied as described in example 1.

The density of the critical current in the superconducting film was of 1.5 MA/cm². Transition temperature was 89 K. No substrate oxidation was observed after 120 min. lasting film deposition process.

The price of the substrate is of 20 DM/m².

### Example 4

A 0.1 mm-thick stainless steel with the composition of Ni 19 %, Cr 18 %, Si 2 %, Mn 2 %, and with the rest of iron was used as the substrate 1. Buffer layer and superconducting film was applied as described in example 1.

The density of the critical current in the superconducting film was of 1.7 MA/cm². Transition temperature was 89 K. No substrate oxidation was observed after 120 min. lasting film deposition process.

The price of the substrate is of 18 DM/m².

### Example 5

A 0.1 mm-thick stainless steel with the composition of Ni 19 %, Cr 28 %, Si 1.5 %, Mn 1 %, and with the rest of iron was used as the substrate 1. Buffer layer and superconducting film was applied as described in example 1.

The density of the critical current in the superconducting film was of 1.5 MA/cm². Transition temperature was 88 K. No substrate oxidation was observed after 120 min. lasting film deposition process.

The price of the substrate is of 25 DM/m².

### Example 6

The stainless steel of example 1 was used, by instead of galvanic polishing the substrate was annealed at 850 °C in vacuum during 2 hours.

The density of the critical current in the superconducting film was of 1.7 MA/cm². Transition temperature was 90 K. No substrate oxidation was observed after 120 min. lasting film deposition process.

The price of the substrate is of 20 DM/m².

### Example 7

A 0.1 mm-thick stainless steel with the composition of Ni 8 %, Cr 18 %, Mn 2 %, and with the rest of iron was used as the substrate 1. Buffer layer and superconducting film was applied as described in example 1.

The density of the critical current in the superconducting film was of 0.1 MA/cm². Transition temperature was 88 K. A pronounced substrate oxidation was observed after 120 min. lasting film deposition process.

The price of the substrate is of 15 DM/m².

### Example 8

A 0.1 mm-thick stainless steel with the composition of Ni 9 %, Cr 18 %, Ti 0,5 %, Mn 2 %, and with the rest of iron was used as the substrate 1. Buffer layer and superconducting film was applied as described in example 1.

The density of the critical current in the superconducting film was of 0.1 MA/cm². Transition temperature was 88 K. A pronounced substrate oxidation was observed after 120 min. lasting film deposition process.

The price of the substrate is of 22 DM/m².

### Example 9

A 0.1 mm-thick stainless steel with the composition of Ni 57 %, Cr 16 %, Fe 6 %, Mo 17 %, W 5 % (Hastelloy C) was used as the substrate 1. Buffer layer and superconducting film was applied as described in example 1.

The density of the critical current in the superconducting film was of 1.5 MA/cm². Transition temperature was 88 K. A local substrate oxidation was observed after 120 min. lasting film deposition process.

The price of the substrate is of 2,700 DM/m².

### Example 10

A 0.1 mm-thick stainless steel with the composition of Ni 100 % (Nickel) was used as the substrate 1. Buffer layer and superconducting film was applied as described in example 1.

The density of the critical current in the superconducting film was of 1.4 MA/cm². Transition temperature was 88 K. A pronounced substrate oxidation was observed after 120 min. lasting film deposition process.

The price of the substrate is of 1,300 DM/m².

### Example 11

A 0.1 mm-thick stainless steel with the composition of Ni 53 %, Cr 19 %, Fe 19 %, Mo 3 %, Nb+Tb 5 %, Ti 1 % (Inconel 718) was used as the substrate 1. Buffer layer and superconducting film was applied as described in example 1.

The density of the critical current in the superconducting film was of 0.15 MA/cm². Transition temperature was 87 K. A local substrate oxidation was observed after 120 min. lasting film deposition process.

The price of the substrate is of 6,300 DM/m².

### Example 12

A 0.1 mm-thick stainless steel with the composition of Ni 72 %, Cr 16 %, Fe 8 %, Mn 1 %, Si 0,5 %, Co (Inconel 600) was used as the substrate 1. Buffer layer and superconducting film was applied as described in example 1.

The density of the critical current in the superconducting film was of 0.1 MA/cm². Transition temperature was 86 K. A local substrate oxidation was observed after 120 min. lasting film deposition process.

The price of the substrate is of 900 DM/m².

The results of the experiments according to the above examples are summarized in Table 1.

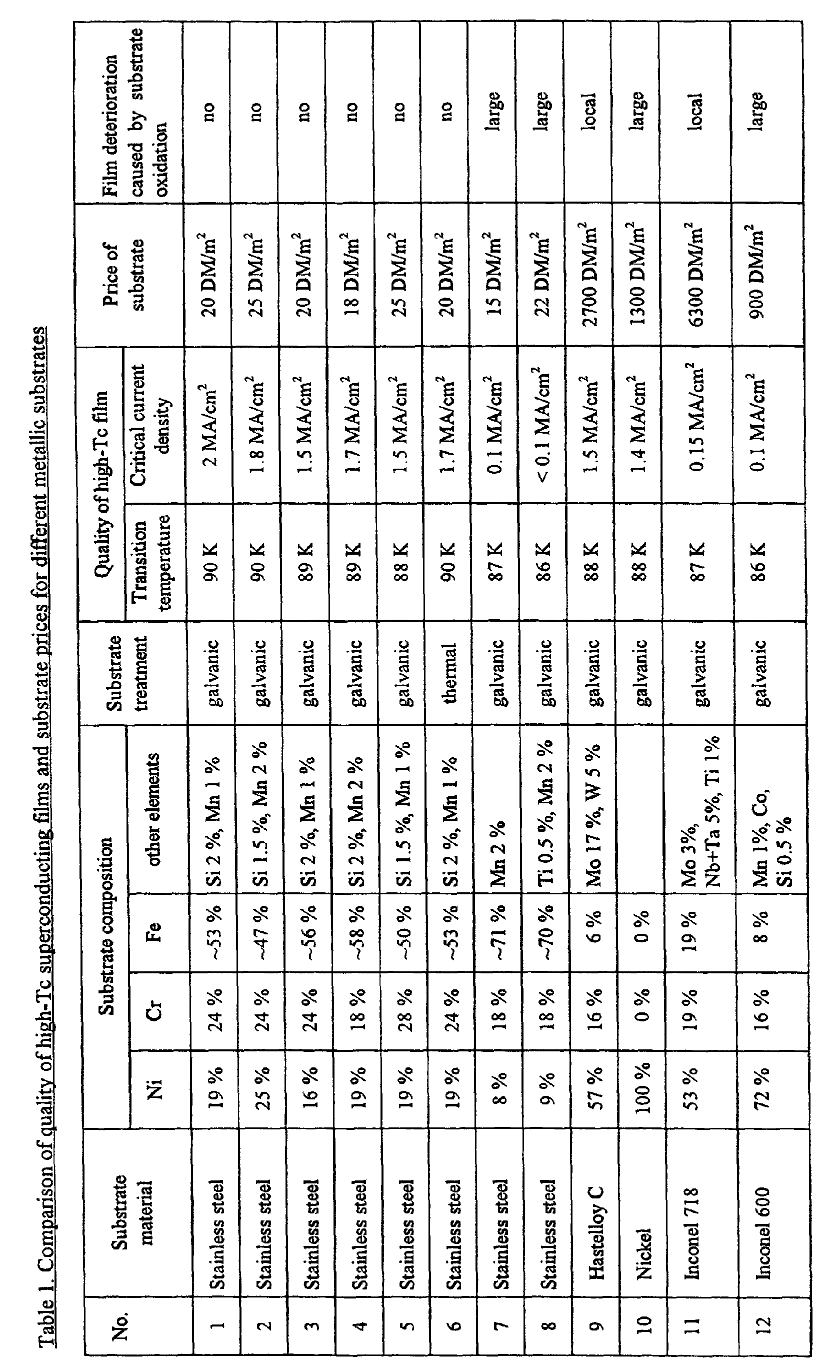

It should be noted that all indications in % are based on weight (wt %).

## Claims

1. Superconducting element comprising a high temperature superconducting film deposited on a technical substrate (1) consisting of a stainless steel containing Ni, Cr, and Fe and possible further alloying elements, preferably Mn and Si, wherein the stainless steel is a heat resistant steel containing 16 to 25 % Ni and 18 to 28 % Cr, rest iron and said possible alloying elements.

2. Superconducting element according to claim 1 wherein said steel shows a heat elongation of 15 to 18 x 10⁻⁶/K between 20° and 400 °C, of 16 to 19 x 10⁻⁶/K between 20° and 800 °C, of 17 to 20 x 10⁻⁶/K between 20° and 1000 °C and of 18 to 20.5 x 10⁻⁶/K between 20° and 1200 °C.

3. Superconducting element according to claim 2 wherein said steel shows an heat elongation of 17 x 10⁻⁶/K between 20° and 400 °C, 18 x 10⁻⁶/K between 20° and 800 °C, of 19 x 10⁻⁶/K between 20° and 1000 °C and of 19.5 x 10⁻⁶/K between 20° and 1200 °C.

4. Superconducting element according to one of claims 1 to 3, wherein said stainless steel contains 19 to 22 % Ni and 24 to 26 % Cr.

5. Superconducting element according to one of the claims 1 to 4, wherein said steel in addition contains 1 to 3 % Si.

6. Superconducting element according to claim 5, wherein said steel contains 1.5 to 2.5 % Si.

7. Superconducting element according to one of the claims 1 to 6, wherein said steel is composed of
| | |
|---|---|
| C | 0 to 0.20 % |
| Si | 1.5 to 2.5 % |
| Mn | 0 to 2.00 % |
| P | 0 to 0.045 % |
| S | 0 to 0.030 % |
| Cr | 24.0 to 26.0 % |
| Ni | 19.0 to 22.0 % |
| N | 0 to 0.11 %, |
rest iron and unavoidable impurities.
